Europäisches Patentamt

European Patent Office

Office européen des brevets

(19)

(11) EP 0 624 949 B1

(12) **FASCICULE DE BREVET EUROPEEN**

(45) Date de publication et mention
de la délivrance du brevet:
**17.03.1999 Bulletin 1999/11**

(51) Int Cl.$^6$: **H03J 3/32**

(21) Numéro de dépôt: **94201268.3**

(22) Date de dépôt: **06.05.1994**

(54) **Appareil comprenant un circuit ayant une réponse entrée/sortie contrôlable par un signal de commande et procédé d'approximation**

Vorrichtung mit einer steuerbaren Übertragungsfunktionsschaltung durch ein Befehlssignal und Näherungsverfahren

Apparatus comprising a circuit with a transfer function which is controllable by a command signal and approximating method

(84) Etats contractants désignés:
**DE FR GB IT**

(30) Priorité: **12.05.1993 FR 9305716**

(43) Date de publication de la demande:
**17.11.1994 Bulletin 1994/46**

(73) Titulaires:
- **LABORATOIRES D'ELECTRONIQUE PHILIPS S.A.S.**
  **94450 Limeil-Brévannes (FR)**
  Etats contractants désignés:
  **FR**
- **Koninklijke Philips Electronics N.V.**
  **5621 BA Eindhoven (NL)**
  Etats contractants désignés:
  **DE GB IT**

(72) Inventeur: **Deville, Yannick**
**156, Boulevard Haussmann, F-75008 Paris (FR)**

(74) Mandataire: **Landousy, Christian et al**
**Société Civile S.P.I.D.**
**156, Boulevard Haussmann**
**75008 Paris (FR)**

(56) Documents cités:
**WO-A-87/02202          DE-A- 3 332 206**
**GB-A- 2 136 230**

- **ELEKTROTECHNIK UND MASCHINENBAU, vol.101, no.10, Octobre 1984, WIEN AT pages 471 - 474 M. ENGLMEIER : 'Ats - ein Fersehtunerabgleichsystem mit Mikroprozessor'**

EP 0 624 949 B1

**Description**

L'invention concerne un appareil comprenant un circuit qui délivre un signal de sortie en réponse à un signal d'entrée, des moyens pour changer des valeurs de ladite réponse par au moins un signal de commande, des moyens de calcul pour déterminer des seconds couples valeurs de réponse / valeurs de signal de commande à partir d'une approximation de premiers couples valeurs de réponse / valeurs de signal de commande issues du circuit.

Elle concerne également un dispositif de codage destiné à être utilisé en coopération avec un tel appareil, comprenant un circuit qui délivre un signal de sortie en réponse à un signal d'entrée, des moyens pour changer des valeurs de ladite réponse par au moins un signal de commande, des moyens de calcul pour déterminer des seconds couples valeurs de réponse / valeurs de signal de commande à partir d'une approximation de premiers couples valeurs de réponse / valeurs de signal de commande issues du circuit.

Elle concerne enfin un procédé pour générer une fonction d'approximation de premiers couples valeurs de réponse / valeurs de signal de commande issues du circuit, et pour déterminer des seconds couples valeurs de réponse / valeurs de signal de commande à partir de ladite fonction d'approximation.

On connaît des circuits électriques ou électroniques ayant des réponses contrôlables à l'aide de composants ayant une propriété variable avec un signal de commande. A titre d'exemple, il est connu d'utiliser des diodes varicap qui présentent la propriété de posséder une capacité variable lorsqu'une tension variable est appliquée aux bornes de la diode. Les variations capacité / tension permettent d'accorder beaucoup de circuits électriques tels que des oscillateurs ou de régler des bandes passantes de filtre. A l'aide d'éléments à conductance variable, on peut de même modifier des gains d'amplificateurs.

Des mécanismes analogues de réglage peuvent être établis avec d'autres éléments tels que : girateurs, transistors ou des éléments composés tels que des amplificateurs opérationnels ou des amplificateurs de transconductance.

De telles unités peuvent être utilisées dans des appareils tels que : téléviseurs, récepteurs radiophoniques, appareils d'enregistrement ou autres.

Dans ces applications il peut être souhaitable de disposer de plusieurs conditions de réglage que l'on peut sélectionner individuellement. Ces conditions de réglage doivent pouvoir être menées à bien avec des procédures rapides et avec peu de moyens matériels.

Il est connu du document DE-A-3 332 206, un procédé d'accord de circuits sélectifs ainsi que le montage pour mettre en oeuvre ce procédé. Ces circuits sélectifs, comprenant des diodes à capacité variable, sont incorporés dans un syntoniseur inclus par exemple dans un récepteur de télévision ou un récepteur radio. Le montage comprend un oscillateur local qui sert à réaliser, généralement en usine, l'alignement des dits circuits sélectifs sur les fréquences de canaux prédéterminés, par modification de signaux de commande appliqués aux dites diodes. L'appareil de ce document ne stocke pas toutes les valeurs de réglages des circuits, ce qui réduit la taille mémoire, et un procédé d'interpolation linéaire est prévu entre deux valeurs stockées, afin de recréer les valeurs qui ne sont pas stockées.

Un des buts de l'invention est de déterminer un procédé qui améliore encore la précision des réglages pour les valeurs non stockées.

L'invention est définie dans les revendications indépendantes 1, 4 et 5.

Une utilisation consiste à sélectionner une valeur prédéterminée de réponse que l'on souhaite obtenir et les moyens de calcul déterminent le signal de commande qui fournit cette réponse à partir de la fonction linéaire de régression.

En considérant que lesdits couples sont représentés par un ensemble de points dans un espace à deux dimensions, la fonction linéaire de régression est représentée par une droite.

Ainsi, avantageusement en réduisant le nombre de points expérimentaux à une fonction linéaire de régression, ceci permet de stocker en mémoire un nombre limité de données et de calculer des valeurs de signal de commande pour les seules valeurs de réponses attendues. Des valeurs approximées de signal de commande peuvent être calculées pour des valeurs de réponse faisant partie des mesures expérimentales. La demande de valeurs prédéterminées de réponse peut être formulée sous forme codée aux moyens de calcul.

Des modes particuliers de réalisation de l'appareil ou du procédé apparaissent dans les revendications dépendantes 2, 3, 6.

L'invention permet avantageusement d'assurer à l'appareil des conditions de fonctionnement qui soient optimales pour des conditions variées d'utilisation.

L'invention peut être mise en oeuvre dans des appareils comprenant des circuits de différents types. Ainsi le circuit peut être un circuit résonnant, un filtre, un oscillateur, un déphaseur, un amplificateur ou autres.

Plus généralement, l'appareil peut être un appareil muni d'un syntoniseur, notamment un récepteur de télévision, un récepteur radiophonique, un magnétoscope ou autres.

L'invention sera mieux comprise à l'aide des figures suivantes données à titre d'exemples non limitatifs qui représentent :

Figure 1 : deux courbes reliant le module de la tension de sortie à la fréquence d'un signal d'entrée d'amplitude constante pour deux circuits accordés.

Figure 2 : une représentation de points de mesure des fréquences d'accord en fonction d'un signal de commande V pour un circuit accordé.

Figure 3 : un schéma d'un appareil selon l'invention avec un dispositif de codage intégré.

Figure 4 : un schéma d'un appareil selon l'invention avec un dispositif de codage externe.

Figure 5 : une représentation de points de mesure avec une droite D de régression.

Figure 6 : deux représentations de droites reliant les variations du gain à fréquence constante et les variations de fréquence à gain constant en fonction d'un signal de commande dans le cas d'un amplificateur.

Figure 7 : un organigramme d'une détermination d'une droite de régression à partir de couples de points de mesure.

Figure 8 : un schéma d'un dispositif de codage d'une droite de régression.

Figure 9 : un schéma d'un dispositif de calcul pour le transcodage de valeurs de réponse en valeurs du signal de commande déduites de plusieurs droites de régression.

Considérons, à titre d'exemple, le cas d'un circuit résonnant à accorder successivement sur plusieurs fréquences d'accord.

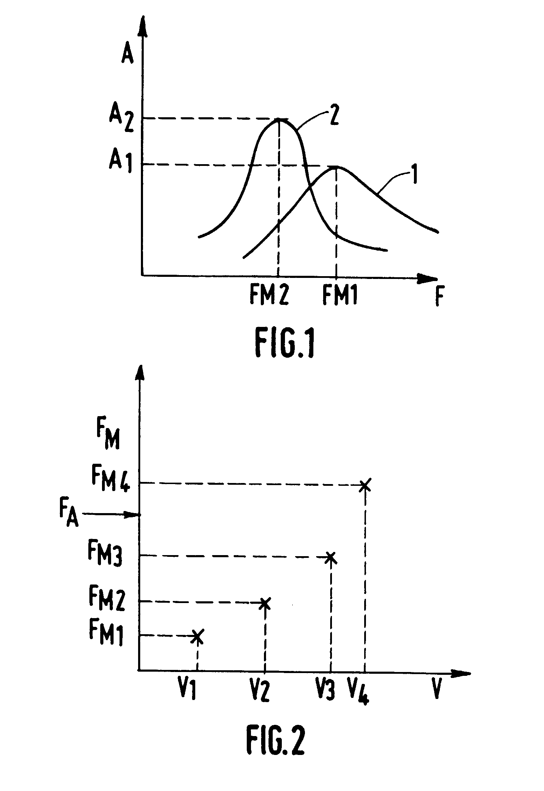

La figure 1 représente une courbe 1 représentant l'amplitude A d'un signal de sortie OUT du circuit résonnant en fonction de la fréquence F d'un signal d'entrée IN d'amplitude constante appliqué en entrée. La courbe 1 présente un maximum à la fréquence $F_{M1}$ avec un signal de sortie $A_1$. Considérons le cas où ce circuit résonnant est muni d'une diode varicap dont la capacité change avec une tension V appliquée aux bornes de la diode varicap. En changeant V, on modifie la fréquence d'accord du circuit résonnant. La courbe 2 représente cette seconde situation avec une fréquence d'accord $F_{M2}$ correspondant à un signal de sortie $A_2$.

La fréquence d'accord du circuit résonnant varie ainsi avec la tension V. La figure 2 représente un exemple de points de mesure de plusieurs fréquences d'accord $F_M$ pour différentes valeurs V. Les points de mesures constituent une suite discrète de points mesurés sur le circuit résonnant considéré. Si l'on désire accorder le circuit résonnant sur une fréquence particulière, par exemple $F_A$ sur la figure 2, il faut reprendre les mesures expérimentales précédentes si l'invention n'était pas mise en oeuvre.

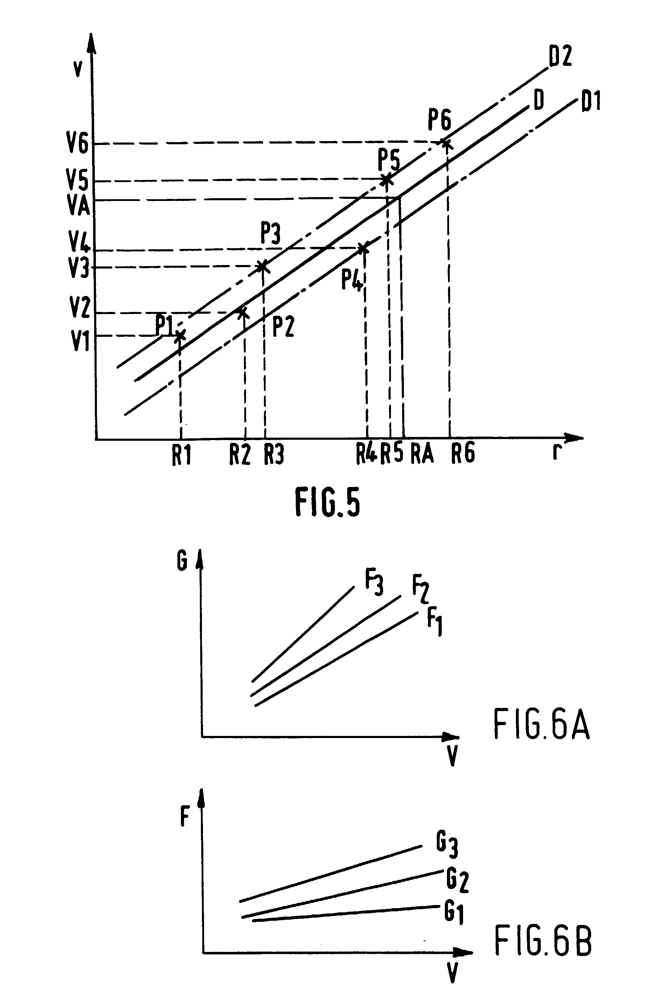

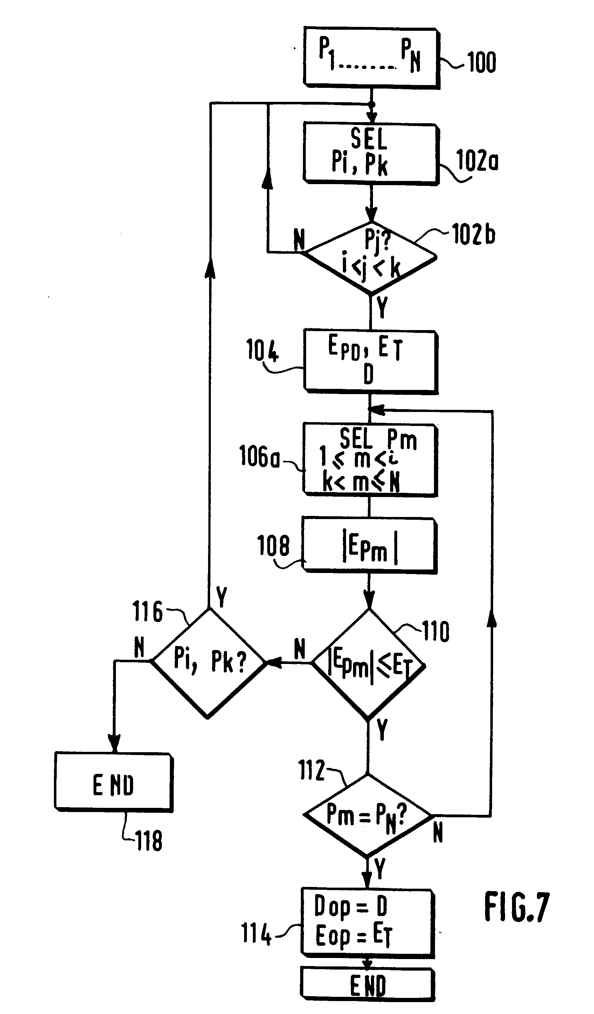

Remarquons que l'axe vertical se rapporte à une grandeur dépendante concernant des fréquences d'accord et que l'axe horizontal se rapporte à une grandeur indépendante concernant des valeurs de signaux de commande. Sur la figure 5, les valeurs de signaux de commande deviennent des grandeurs dépendantes et les valeurs de réponse deviennent des grandeurs indépendantes. Par la suite, on ordonne les points d'après un ordre croissant des valeurs de grandeur indépendante, ce qui définit un indice i croissant avec lesdites valeurs. Une convention inverse peut être faite en modifiant en conséquence l'exposé ci-après.

L'invention se propose de déduire la tension de commande à appliquer sur la varicap permettant d'accorder le circuit résonnant sur la fréquence d'accord $F_A$, à partir d'une approximation des points de mesures déjà prélevés, sans procéder à de nouvelles expérimentations.

La fréquence d'accord $F_A$ peut d'ailleurs être égale à une fréquence d'accord qui a donné lieu à une mesure de couple de valeurs expérimentales.

Ce mode opératoire est avantageux particulièrement sur des chaînes de montage de circuits résonnants sur lesquelles à partir d'un nombre réduit de points de mesures, il est possible de déduire tous les signaux de commande nécessaires pour accorder le circuit résonnant pour toutes les fréquences de réception. La même procédure s'applique par exemple dans le cas de la maintenance d'un appareil pour tenir compte du vieillissement des composants électroniques du circuit résonnant. Il suffit alors d'effectuer un relevé de quelques mesures expérimentales et l'invention permet d'en déduire toutes les autres valeurs.

A partir de la suite discrète de points de mesures reliant les coordonnées des couples valeurs de réponse/ valeurs de signal de commande, l'invention détermine une approximation sous forme d'au moins une droite de régression.

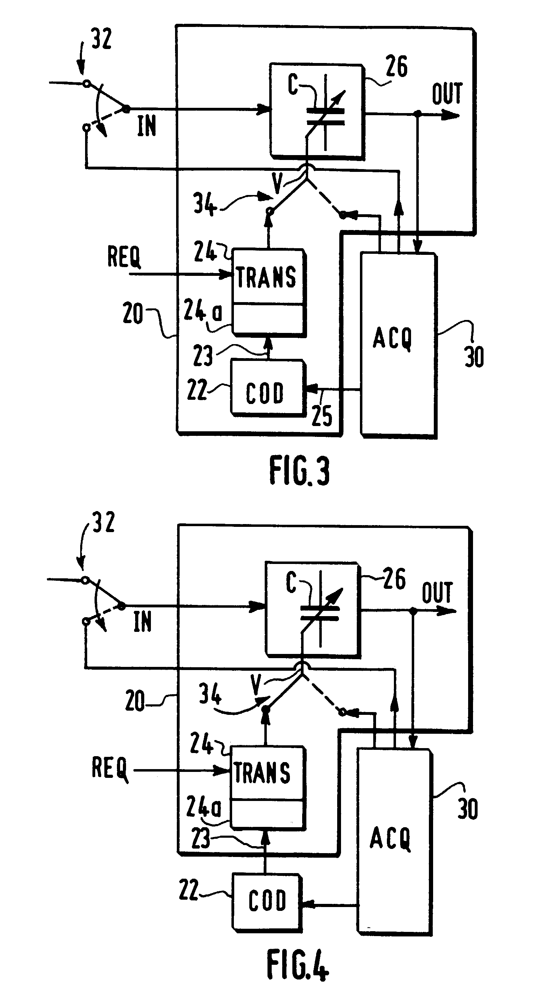

La figure 3 représente un appareil 20 muni, selon l'invention, de moyens de codage COD 22 qui déterminent la droite de régression et qui codent ladite droite, et des moyens de calcul TRANS 24 qui reçoivent les codes (connexion 23) et qui, à partir d'un signal de requête REQ, effectuent un transcodage pour délivrer un signal de commande V à un circuit 26.

Pour opérer, le codeur 22 doit recevoir des points de mesures prélevés par une unité ACQ 30 de mesure externe. Au cours de cette procédure d'acquisition de points de mesures, l'unité 30 est connectée, par un sélecteur 32, à l'entrée du circuit 26. Un signal d'amplitude connue et de fréquence connue est appliqué à l'entrée du circuit 26 par l'appareil 30. Le signal OUT de sortie est mesuré par l'unité 30. Un sélecteur 34 permet à l'unité 30 d'appliquer un signal de commande V sur le circuit 26 par exemple une diode capacitive C. En faisant varier la fréquence du signal d'entrée ainsi que la valeur de la tension de commande, il est ainsi possible d'acquérir plusieurs points de mesures reliant le signal de commande à la réponse considérée du circuit, par exemple ses fréquences d'accord. Ces points de mesures sont transmis au codeur 22 pour la suite du traitement.

Il est également possible de faire que le codeur 22 ne fasse pas partie intégrante de l'appareil. Il peut en effet s'agir d'un dispositif 22 de codage externe, par exemple situé en usine pour la mise au point de l'appareil ou dans un service de maintenance. La figure 4 représente une figure semblable à la figure 3 sur laquelle le dispositif de codage 22 est à l'extérieur de l'appareil 20.

Les points de mesures étant acquis, le codeur 22 va devoir déterminer la ou les droites de régression optimales. Pour cela considérons la figure 5 sur laquelle, à titre d'exemple on a représenté six points de mesures $P_1$ à $P_6$ dans une représentation à deux dimensions.

Chacun de ces points est défini par un couple de valeurs (v, r) reliant une valeur v de signal de commande à une valeur r de réponse par exemple une fréquence d'accord maximal.

On ordonne les points d'après un ordre croissant des valeurs d'abscisses $R_i$, ce qui définit un indice i croissant avec lesdites valeurs. Une convention inverse peut être faite en modifiant en conséquence l'exposé ci-après.

Selon l'invention on effectue une approximation de l'ensemble des couples $(R_1, V_1)$, $(R_2, V_2)$... par une droite de régression D ayant pour équation :

$$(1) \qquad D : v = p.r + q.$$

où v et r sont des variables courantes.

Le principe consiste à sélectionner trois couples de valeurs, par exemple $(R_3, V_3)$, $(R_4, V_4)$, $(R_5, V_5)$, et à déterminer une droite de régression D par équilibrage des erreurs absolues. Une erreur est mesurée par la différence apparaissant, pour une abscisse r donnée, entre la valeur v du point et l'abscisse v mesurée sur la droite de régression. Equilibrer les erreurs sur trois points, consiste à avoir trois erreurs égales en valeur absolue avec un signe d'erreur opposé aux deux autres pour le point ayant une abscisse r comprise entre les abscisses r des deux autres points. Puis on examine si pour les points restants de l'ensemble, l'erreur qui les sépare de la droite reste inférieure ou égale en valeur absolue à l'erreur préalablement déterminée pour les trois points sélectionnés. Ceci découle du fait que l'on s'intéresse à une erreur pire cas relative à l'ensemble de tous les points à prendre en considération c'est-à-dire la plus grande erreur en valeur absolue qui existe entre un des points et la droite de régression. Si toutes les erreurs sont effectivement inférieures ou égales, la droite est sélectionnée pour représenter les points sinon on recommence les opérations avec trois nouveaux couples de valeurs pour déterminer une autre droite de régression.

Il peut exister plusieurs droites de régression représentant tous les points de l'ensemble. Selon le procédé on détermine la droite de régression optimale qui minimise l'erreur pire cas définie préalablement.

La figure 5 représente un exemple formé de six points $P_1$ à $P_6$ disposés selon une représentation à deux dimensions. A des fins d'explication considérons le résultat final. On observe que la droite de régression D est située de sorte que les erreurs sont égales en valeur absolue pour les points $P_3$, $P_4$ et $P_5$. Pour les points $P_1$, $P_2$, $P_6$ les erreurs sont inférieures aux précédentes en valeur absolue. Dans un ensemble de points $P_1$ à $P_6$, le procédé va ainsi consister à rechercher les trois points particuliers ici $P_3$, $P_4$, $P_5$ qui permettent de déterminer la droite de régression optimale qui minimise l'erreur pire cas puis à coder cette droite. Dans le cas de la figure 5 représentant un résultat final, si on trace deux droites $D_1$ et $D_2$, parallèles à la droite de régression D, qui passent par les points $P_3$, $P_4$, $P_5$ définissant la droite de régression D, on constate que tous les points de l'ensemble sont à l'intérieur d'un bandeau limité par les droites $D_1$ et $D_2$ ou sur ces droites.

La phase de détermination de la droite de régression peut donner lieu à plusieurs mises en oeuvre dont seule la plus avantageuse est décrite ci-après.

Pour choisir le triplet de points, on commence par déterminer une paire de points auquel on adjoint un autre point. D'autre part, la détermination de la droite de régression tient compte du fait qu'une précision identique est souhaitable sur toute l'étendue de la gamme de mesure pour la fréquence d'accord réelle du circuit. Ainsi des fréquences d'accord se situant dans des gammes différentes ne réclament pas une précision identique en ce qui concerne le signal de commande généré par les moyens de transcodage. Pour cela préférentiellement selon l'invention, on pondère par des coefficients de pondération W, les approximations faites en fonction du point de mesure. Ces coefficients sont proportionnels aux valeurs absolues de la dérivée de la courbe de fréquence d'accord réelle en fonction du signal de commande.

Les coefficients de pondération peuvent être communs à plusieurs points ou être spécifiques à chaque point. Ces coefficients de pondération $W_i$ sont, par la suite, considérés strictement positifs.

Dans les cas où des coefficients de pondération existent, on définit une erreur $E_{PD}$ entre un point $P_i$ et la droite de régression D tel que :

$$(2) \qquad E_{PD}(P_i, D) = W_i.[V_i - (p.R_i + q)]$$

où $E_{PD}$ est une valeur signée. La détermination de la droite de régression D pour trois points $P_i$, $P_j$, $P_k$ tels que i < j < k nécessite de calculer des quantités p et q tel que :

$$p = NUMP/DET \text{ et } q = NUMQ/DET$$

où les quantités NUMP, NUMQ et DET sont définies par :

$$DET = W_i \cdot W_j \cdot (R_j \text{-} R_i) + W_j \cdot W_k \cdot (R_k \text{-} R_j) + W_i \cdot W_k \cdot (R_k \text{-} R_i)$$

$$NUMP = W_i \cdot W_j \cdot (V_j \text{-} V_i) + W_j \cdot W_k \cdot (V_k \text{-} V_j) + W_i \cdot W_k \cdot (V_k \text{-} V_i)$$

$$NUMQ = W_i \cdot W_j \cdot (R_j \cdot V_i \text{-} R_i \cdot V_j) + W_j \cdot W_k \cdot (R_k \cdot V_j \text{-} R_j \cdot V_k)$$
$$+ W_i \cdot W_k \cdot (R_k \cdot V_i \text{-} R_i \cdot V_k)$$

Par ailleurs, l'erreur $E_T$ associée à ce triplet peut être exprimée et calculée par :

$$E_T(P_i, P_j, P_k) = \left| E_{PD}(P_i, D) \right|$$

avec
$$E_{PD}(P_i, D) = \text{-} E_{PD}(P_j, D) = E_{PD}(P_k, D)$$
ou

$$(3) \qquad E_T = \frac{W_i \cdot W_j \cdot W_k \cdot | (R_i \cdot V_j \text{-} R_j \cdot V_i) + (R_j \cdot V_k \text{-} R_k \cdot V_j) + (R_k \cdot V_i \text{-} R_i \cdot V_k) |}{DET}$$

On sélectionne d'abord une paire de points auxquels on ajoute un point supplémentaire, situé entre ces deux points, afin de former un triplet de points. Pour cela, (figure 7) on opère une sélection (102a) d'une paire $P_i$, $P_k$ de points appartenant audit ensemble, tel qu'il existe au moins un point intermédiaire $P_l$ ayant une variable $R_l$ comprise entre les variables $R_i$ et $R_k$ de la paire pour constituer au moins un triplet de points.

Pour les points $P_i$, $P_l$, $P_k$ qui forment le triplet, on définit un facteur $F_l$ qui relie les points $P_i$, $P_l$, $P_k$ en ce qui concerne leurs coordonnées respectives et leurs coefficients de pondération respectifs. Au point central 1, on associe le facteur $F_l$ tel que :

$$F_l = \frac{W_l}{R_k \text{-} R_i} \cdot \left[ \frac{R_l \text{-} R_i}{W_k} + \frac{R_k \text{-} R_l}{W_i} \right]$$

Ce facteur $F_l$ intervient dans la détermination du point intermédiaire $P_l$ qui sera à sélectionner (i < 1 < k) pour constituer le triplet en tenant compte des poids affectant les points. On cherche d'abord à former une droite de régression située en dessous de $P_i$ et $P_k$. Pour chaque point intermédiaire $P_l$, on calcule la droite de régression $D_l$ associée au triplet $P_i$, $P_l$, $P_k$ et l'erreur $R_{Tl}$ associée au triplet. Pour chaque point intermédiaire $P_l$, on détermine si $F_l = 1$ et $E_{PD}$ $(P_i, D_l) < 0$. Si au moins un point vérifie cette condition, il n'existe pas de droite de régression située en dessous de $P_i$ et $P_k$, sinon on détermine une grandeur $G_{max}$ qui est la quantité maximale parmi :

.   d'une part les quantités $E_{PD}$ $(P_i, D_l)$ pour tous les points intermédiaires,
.   d'autre part les quantités (a) suivantes uniquement pour les points intermédiaires pour lesquels $F_l < 1$ avec

$$(a) \qquad \frac{F_l + 1}{F_l \text{-} 1} \cdot E_{PD} \ (P_i, D_l) \, .$$

S'il existe au moins un point intermédiaire tel que $F_l > 1$, on définit également une grandeur $G_{min}$ qui est la valeur minimale prise par (a) uniquement pour les points intermédiaires tels que $F_l > 1$. On examine alors s'il existe au moins un point intermédiaire tel que :

$$E_{PD} (P_i, D_l) \geq 0$$

$$G_{max} \leq \alpha\, E_{Tl}$$

et

$$G_{min}.\ \alpha \geq E_{Tl}\ (\alpha : \text{coefficient} \geq 1).$$

S'il existe un tel point, il est choisi comme point intermédiaire pour former le triplet.

S'il n'existe pas de point intermédiaire tel que $F_l > 1$, on teste s'il existe au moins un point intermédiaire tel que :

$$E_{PD} (P_i, D_l) \geq 0$$

$$G_{max} \leq \alpha.\ E_{Tl}\ (\alpha : \text{coefficient} \geq 1).$$

Si un tel point existe, il est choisi comme point intermédiaire pour former le triplet.

Si aucun triplet n'a été constitué, on cherche à former une droite de régression située au-dessus des points $P_i$ et $P_k$. Le même procédé est repris en inversant le signe des erreurs $E_{PD}$.

Si aucun point $P_l$ ne peut être sélectionné, on recommence avec une autre paire $P_i$; $P_k$.

Lorsque l'erreur $E_T$ a été calculée pour le triplet $P_i$, $P_l$, $P_k$, on examine si les autres points de l'ensemble engendrent des erreurs inférieures ou égales en valeur absolue à celles des points $P_i$, $P_l$, $P_k$. Pour cela on sélectionne un point $P_m$ (bloc 106a) additionnel dont l'abscisse r est extérieure aux abscisses $R_i$, $R_k$ et on calcule la valeur absolue de l'erreur $E_{Pm}$ (bloc 108) apparaissant entre la valeur de la variable v au point $P_m$ et la droite D.

Lorsque cette erreur $E_{Pm}$ est inférieure ou égale en valeur absolue à $E_T$ (bloc 110) (repère Y), le point $P_m$ additionnel est accepté et le procédé se poursuit (bloc 112) avec un point additionnel suivant (bloc 106a). Si tous les points additionnels satisfont au critère $| E_{Pm} | \leq E_T$, la droite D est acceptée et ses coefficients sont utilisés pour coder la droite de régression D (bloc 114).

Lorsque cette erreur $E_{Pm}$ est supérieure à $E_T$ (bloc 110), (repère N), le triplet de points $P_i$, $P_l$, $P_k$ sélectionné n'est pas accepté et un autre triplet de points (bloc 116) est choisi dans l'ensemble de points (blocs 102a, 102b). Le procédé s'achève à l'obtention de la droite D (bloc 114) satisfaisant ce critère même si tous les triplets de points n'ont pas été examinés.

Il peut apparaître des situations où à l'issue de l'étape 116 tous les points possibles ont été examinés et aucun des triplets n'a fourni de solution (bloc 118). Dans ce cas, il est possible de reprendre le déroulement en augmentant $\alpha$ et/ou en remplaçant le test du bloc 110 par le test suivant :

$$| E_{Pm} | \leq \beta.E_T$$

où $\beta$ est un coefficient légèrement supérieur à 1.

D'autres procédés peuvent être mis en oeuvre par l'homme du métier pour déterminer la ou les droites de régression.

Il est par exemple possible de choisir aléatoirement un triplet de points, de déterminer la droite de régression comme indiqué ci-dessus et de tester si les erreurs qui en découlent pour les autres points sont plus faibles que pour le triplet choisi. Dans le cas inverse, on recommence avec un autre triplet.

On peut également déterminer les droites de régression correspondant à tous les triplets réalisables dans la suite de points, et sélectionner la droite de régression qui fournit la plus grande erreur de triplet.

Il est aussi possible de déterminer une enveloppe supérieure et/ou une enveloppe inférieure qui passe par les points extrêmes de l'ensemble des points de mesures consignés sur un diagramme bidimensionnel, et de choisir des paires de points adjacents appartenant à l'une ou l'autre enveloppe. Le troisième point, pour former un triplet, étant alors un point ayant une abscisse intermédiaire entre les abscisses des points de la paire choisie.

D'autres procédés qui déterminent d'autres fonctions linéaires par morceaux en réalisant une approximation des couples de valeurs mesurées sur le circuit en garantissant une erreur faible d'approximation peuvent être utilisées dans l'appareil selon l'invention.

Lorsque l'ensemble de points à traiter est trop important pour être représenté par une seule droite de régression, il est possible de représenter cet ensemble par plusieurs droites de régression ayant chacune un domaine défini de validité. Le procédé décrit ou d'autres procédés peuvent être utilisés pour définir ces droites de régression.

Les droites sont déterminées à partir d'une suite discrète et limitée de points de mesure. Néanmoins, pour l'exploitation des droites de régression, il est nécessaire de définir leur domaine d'existence qui s'étend sur un continum de valeurs situées entre deux limites d'abscisses. Or la détermination des droites fournit une suite de droites qui ne se raccordent pas nécessairement par leurs extrémités.

Il peut apparaître utile pour certaines applications d'assurer le raccordement de deux droites de régression successives pour éviter des variations brutales sur l'une ou l'autre grandeur. Lorsque les droites de régression ont été déterminées, une solution peut consister à remplacer une extrémité d'une première droite de régression par l'extrémité la plus proche d'une seconde droite de régression adjacente et à recalculer les codes de la première droite qui devient une première droite de régression modifiée. Tout autre procédé convient. Le raccordement des différents segments de droite de régression entre eux est particulièrement utile par exemple dans le réglage d'un syntoniseur sur différents canaux de réception.

Les différents procédés qui viennent d'être décrits pour déterminer la fonction linéaire de régression peuvent être mis en application dans un dispositif de codage 10 (figure 8) qui comprend :

- une mémoire 12c MEM qui stocke notamment toutes les valeurs appartenant à l'ensemble de points à traiter. Ces points sont représentés par leurs coordonnées (R, V), et éventuellement leurs poids W ou leurs inverses 1/W,
- une unité de calcul 13c COMPUT qui détermine les points intermédiaires et forme les triplets, par exemple issus des paires de points $P_i$, $P_k$, et qui calcule, pour chaque triplet sélectionné, la droite de régression adaptée à chaque triplet, c'est-à-dire les codes p, q de la droite et l'erreur $E_T$ associée au triplet.

De plus, un contrôleur 11c CONTR permet d'effectuer la gestion des opérations et d'adresser des nouveaux triplets en effectuant les lectures/écritures de la mémoire 12c et le chargement de l'unité de calcul 13c par de nouveaux triplets. La sélection de la droite de régression qui est à conserver peut être obtenue en choisissant celle qui délivre la plus grande erreur de triplet. Cette sélection est effectuée par l'unité de calcul 13c.

Egalement, selon le procédé préférentiel décrit sur la figure 7, il est possible, pour chaque droite courante de régression, d'examiner si les autres points additionnels de la suite délivrent une erreur inférieure à l'erreur de triplet. Pour cela, le dispositif de codage 22 comprend une unité de comparaison 14c.

L'unité de calcul 13c, transmet les codes p, q de la droite de régression du triplet courant à l'unité de comparaison 14c COMPAR qui détermine si les points additionnels de l'ensemble de points génèrent une erreur plus faible avec cette droite de régression que celle générée par les points du triplet courant. Pour cela, l'unité de comparaison 14c effectue le test :

$$|E_{Pm}| > E_T$$

Si la droite de régression courante n'est pas acceptée (test positif), un autre triplet est sélectionné et une procédure analogue est à nouveau effectuée. Si le test est négatif pour tous les points additionnels, la droite de régression est acceptée et ses paramètres sont chargés par l'unité de calcul 13c dans la mémoire 12c. La mémoire 12c reçoit ainsi soit les codes p, q soit les coordonnées d'extrémités (x, y) des droites de régression formant l'approximation des couples expérimentaux.

L'unité de calcul 13c peut également être programmée pour déterminer au préalable les enveloppes. L'unité de comparaison 14c effectue ensuite les comparaisons des erreurs se rapportant aux différents triplets issus des enveloppes.

Pour effectuer la gestion des opérations et adresser des nouveaux triplets (lorsque des triplets examinés n'ont pas donné satisfaction), le contrôleur 11c gère :

- les lectures/écritures de la mémoire 12c,
- le chargement de l'unité de calcul 13c par une paire de points pour laquelle on détermine le point intermédiaire $P_I$ pour constituer des nouveaux triplets,
- l'appel vers l'unité de comparaison 14c de tous les points additionnels à examiner successivement.

Une fois déterminés les codes sont transmis au transcodeur 24 (figure 9) où ils sont chargés dans une mémoire 12a qui est adressée par un contrôleur 11a pour fournir les codes des droites de régression adressées formés, par exemple, des valeurs des grandeurs r, v aux extrémités des segments de droites de régression. La mémoire 12a, organisée en lignes par exemple, contient pour chaque droite de régression les valeurs r et v définissant l'étendue de chaque droite de régression.

Il est possible également de stocker les codes p et q des droites de régression calculées ainsi que les étendues de leur domaine d'application.

Le transcodeur 24 comprend :

- le contrôleur $11_a$,
- la mémoire $12_a$,
- et une unité de traitement $13_a$. Celle-ci reçoit une requête formée d'une valeur de la variable $R_A$ pour laquelle on désire obtenir un résultat $V_A$ d'après la fonction d'approximation caractérisant l'ensemble de points. Pour cela le contrôleur $11_a$ présente successivement des lignes de codes de la mémoire $12_a$. L'unité de traitement teste quelle droite est concernée par cette valeur $R_A$ en comparant celle-ci aux coordonnées d'extrémités des droites. Ce test est effectué dans un comparateur 33. Ensuite à partir des coordonnées d'extrémité de la droite sélectionnée, par exemple celle d'ordre n, l'unité de traitement 13a calcule par exemple la pente $p_n$ de la droite.

Pour cela les valeurs $r_{n+1}$ et $v_{n+1}$ arrrivent sur l'entrée d'une unité de calcul 30 ainsi que des valeurs $r_n$ et $v_n$ préalablement chargées respectivement dans des registres 31, 32.

Ensuite l'unité 30 détermine la grandeur :

$$V_A = p_n(R_A\text{-}r_n) + V_n$$

La donnée $R_A$ peut être introduite dans le transcodeur soit non codée soit codée. Ainsi par exemple lorsque l'on désire accorder le circuit résonnant sur une fréquence $F_A$ déterminée, il est possible que le dispositif soit défini pour recevoir une fréquence définie en Hertz. Mais il est également possible que la/les fréquences $F_A$ aient été au préalablement codées pour être accessibles par des mots de codes $C_r$. Dans ce cas, un décodeur 35 transforme le mot de code $C_r$ en la valeur $R_A$. Préférentiellement le dispositif de transcodage 24 est prévu pour recevoir directement les mots de code $C_r$, les paramètres stockés ($C_r$, v) dans la mémoire 12a étant déterminés en conséquence.

L'invention a été décrite dans le cas préférentiel où la grandeur est une fréquence d'accord d'un circuit résonnant. Elle est également valable lorsqu'il s'agit de régler une fréquence de coupure d'un filtre par un signal de commande externe. De même il peut s'agir de définir un gain d'un amplificateur. Dans ce cas, il peut s'agir de définir une fréquence pour laquelle l'amplificateur fournit un gain prédéterminé. On peut ainsi déterminer la fonction d'approximation à partir de points de mesures reliant une fréquence limite à une tension de commande pour un gain constant.

La mise en oeuvre du procédé consiste alors à déterminer la tension de commande qui, pour une fréquence choisie, assure ledit gain constant. La réponse à laquelle on s'intéresse reste liée à la relation gain-tension de commande mais la requête REQ est introduite dans le transcodeur sous la forme d'une fréquence déterminée, sous-entendu pour laquelle on veut que le gain ait la valeur constante précédente. Le décodeur 35 assure la conversion des données.

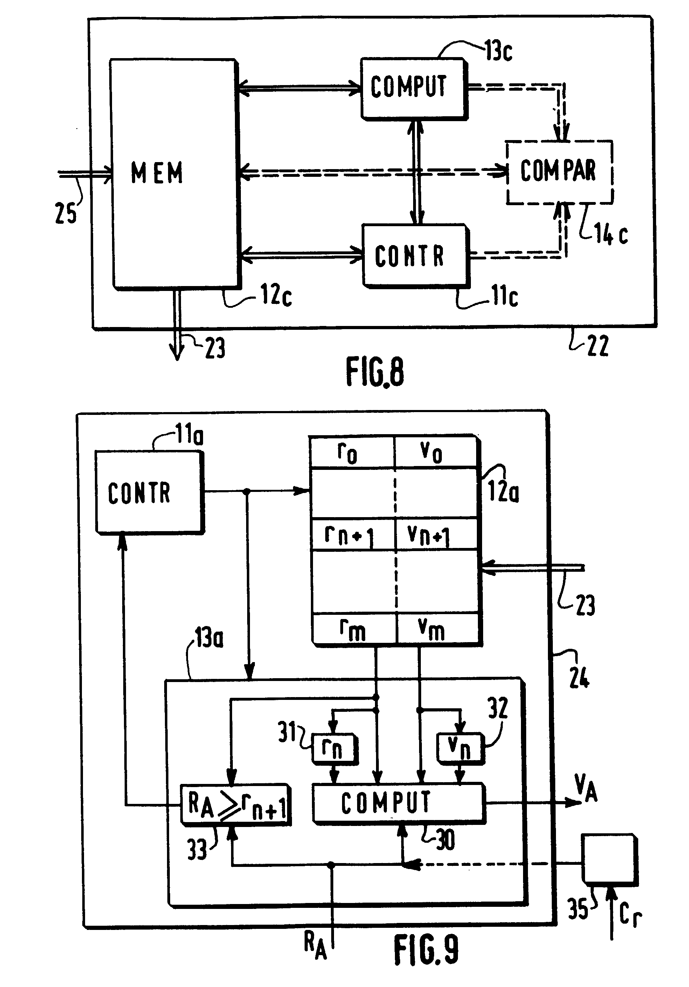

Les mesures expérimentales pourront être acquises soit en mesurant le gain G en fonction de la tension de commande à différentes fréquences constantes $F_1$, $F_2$, $F_3$ (figure 6-A) soit en mesurant la fréquence F en fonction de la tension de commande à gain constant $G_1$, $G_2$, $G_3$ (figure 6-B). Préférentiellement l'invention met en oeuvre cette seconde représentation, bien que la réponse à laquelle on s'intéresse est d'imposer un gain.

De même il peut s'agir d'assurer un déphasage déterminé dans un déphaseur. La requête est là aussi formulée en termes de fréquence choisie à laquelle on désire que le déphasage ait une valeur prédéterminée.

Ainsi pour pouvoir déterminer la tension de commande produisant un déphasage de 90° à une fréquence donnée, il faut au préalable acquérir des points de mesures reliant la fréquence à la tension de commande pour une valeur prédéterminée du déphasage. Une droite de régression est ainsi déduite. On peut ainsi effectuer une requête REQ, exprimée en terme de fréquence, qui déterminera la valeur de la tension de commande pour obtenir le déphasage prédéfini pour la fréquence déterminée par la requête REQ.

**Revendications**

1. Appareil (20) comprenant un circuit (26) qui délivre un signal de sortie (OUT) en réponse à un signal d'entrée (IN),

EP 0 624 949 B1

des moyens (C) pour changer des valeurs (R) de ladite réponse par au moins un signal de commande (V), des moyens de calcul (24) pour déterminer des seconds couples valeurs de réponse, valeurs de signal de commande (RA,VA), à partir d'une approximation de premiers couples valeurs de réponse, valeurs de signal de commande (R1,V1,R6,V6) issues du circuit (26), caractérisé en ce que l'appareil comprend des premiers moyens

- pour déterminer itérativement au moins une fonction linéaire qui réduit des données d'un phénomène complexe en vue de le représenter par une fonction simplificatrice, dite fonction de régression (D), formant l'approximation d'une suite desdits premiers couples (R1,V1)(R6,V6), en rendant égales, en valeur absolue, des premières erreurs, de signes alternés, mesurées entre des premières valeurs ($V_3$, $V_4$, $V_5$) de la grandeur dépendante pour trois couples ($R_3$, $V_3$) ($R_4$, $V_4$) ($R_5$, $V_5$) de ladite suite et respectivement des secondes valeurs ($V'_3$, $V'_4$, $V'_5$) de la grandeur dépendante déterminées d'après ladite fonction linéaire pour les mêmes valeurs ($R_3$, $R_4$, $R_5$) de la grandeur indépendante,
- pour sélectionner celle des fonctions linéaires courantes qui délivre l'approximation de tous les couples de ladite suite avec des erreurs minimales,
- et pour coder la fonction linéaire de régression sélectionnée à l'aide de codes spécifiques,

et des seconds moyens pour calculer à partir des dits codes spécifiques des valeurs (VA) de signal de commande appartenant aux dits seconds couples (RA, VA) pour des valeurs prédéterminées (REQ) de réponse.

2. Appareil selon la revendication 1, caractérisé en ce que le circuit (26) est un circuit résonnant, un filtre, un oscillateur, un déphaseur, un amplificateur.

3. Appareil selon l'une des revendications 1 ou 2, caractérisé en ce qu'il s'agit d'un appareil muni d'un syntoniseur, notamment un récepteur de télévision, un récepteur radiophonique, un magnétoscope.

4. Dispositif de codage (22) destiné à être utilisé en coopération avec un appareil (20) comprenant un circuit (26) qui délivre un signal de sortie (OUT) en réponse à un signal d'entrée (IN), des moyens (C) pour changer des valeurs (R) de ladite réponse par au moins un signal de commande (V), des moyens de calcul (24) pour déterminer des seconds couples valeurs de réponse, valeurs de signal de commande (RA, VA), à partir d'une approximation de premiers couples valeurs de réponse, valeurs de signal de commande (R1,V1,R6,V6) issues du circuit (26), caractérisé en ce que le dispositif de codage (22) comprend des moyens

- pour déterminer itérativement au moins une fonction linéaire qui réduit des données d'un phénomène complexe en vue de le représenter par une fonction simplificatrice, dite fonction de régression (D), formant l'approximation d'une suite desdits premiers couples (R1,V1)(R6,V6) en rendant égales, en valeur absolue, des premières erreurs, de signes alternés, mesurées entre des premières valeurs ($V_3$, $V_4$, $V_5$) de la grandeur dépendante pour trois couples ($R_3$, $V_3$) ($R_4$, $V_4$) ($R_5$, $V_5$) de ladite suite et respectivement des secondes valeurs ($V'_3$, $V'_4$, $V'_5$) de la grandeur dépendante déterminées d'après ladite fonction linéaire pour les mêmes valeurs ($R_3$, $R_4$, $R_5$) de la grandeur indépendante,
- pour sélectionner celle des fonctions linéaires courantes qui délivre l'approximation de tous les couples de ladite suite avec des erreurs minimales,
- et pour coder la fonction linéaire de régression sélectionnée à l'aide de codes spécifiques,

5. Pour un circuit (26) qui délivre un signal de sortie (OUT) en réponse à un signal d'entrée (IN) dans lequel des valeurs (R) de réponse peuvent être changées par au moins un signal de commande (V), procédé pour générer une fonction d'approximation de premiers couples valeurs de réponse, valeurs de signal de commande (R1,V1,R6,V6) issues du circuit, et pour déterminer des seconds couples valeurs de réponse, valeurs de signal de commande (RA,VA) à partir de ladite fonction d'approximation, caractérisé en ce que le procédé comprend une première phase

- pour déterminer itérativement au moins une fonction linéaire qui réduit des données d'un phénomène complexe en vue de le représenter par une fonction simplificatrice, dite fonction de régression (D), formant l'approximation d'une suite desdits premiers couples (R1,V1)(R6,V6), en rendant égales, en valeur absolue, des premières erreurs, de signes alternés, mesurées entre des premières valeurs ($V_3$, $V_4$, $V_5$) de la grandeur dépendante pour trois couples ($R_3$, $V_3$) ($R_4$, $V_4$) ($R_5$, $V_5$) de ladite suite, et respectivement des secondes valeurs ($V'_3$, $V'_4$, $V'_5$) de la grandeur dépendante déterminées d'après ladite fonction linéaire pour les mêmes valeurs ($R_3$, $R_4$, $R_5$) de la grandeur indépendante,
- pour sélectionner celle des fonctions linéaires courantes qui délivre l'approximation de tous les couples de

9

ladite suite avec des erreurs minimales,
- et pour coder la fonction linéaire de régression sélectionnée à l'aide de codes spécifiques,

et une seconde phase pour calculer, à partir des dits codes spécifiques, des valeurs (VA) de signal de commande appartenant aux dits seconds couples (RA, VA) pour des valeurs prédéterminées (REQ) de réponse.

6. Procédé selon la revendication 5, caractérisé en ce qu'à chaque couple de valeurs est associé un coefficient spécifique de pondération qui pondère ladite première erreur s'y rapportant.

**Patentansprüche**

1. Vorrichtung (20) mit einer Schaltung (26), die als Reaktion auf ein Eingangssignal (IN) ein Ausgangssignal (OUT) abgibt, Mittel (C), um die Werte (R) der besagten Reaktion über mindestens ein Befehlssignal (V) zu ändern, Berechnungsmittel (24) zur Bestimmung der zweiten Übertragungswertepaare, Befehlssignalwerte (RA, VA), ausgehend von einer Näherung erster aus der Schaltung (26) kommender Übertragungswertepaare, Befehlssignalwerte (R1,V1,R6,V6), dadurch gekennzeichnet, daß die Vorrichtung erste Mittel enthält,

- um iterativ mindestens eine Linearfunktion zu bestimmen, die die Daten eines komplexen Systems zu dessen Darstellung mit einer vereinfachenden Funktion reduziert, die besagte Regressionsfunktion (D) die Näherung einer Folge der besagten ersten Paare (R1,V1)(R6,V6) bildet, durch Gleichmachung in absolutem Wert von ersten Fehlern abwechselnder Zeichen, gemessen zwischen ersten Werten ($V_3$, $V_4$, $V_5$) der abhängigen Größe für drei Paare ($R_3$, $V_3$) ($R_4$, $V_4$) ($R_5$, $V_5$) der besagten Folge und respektive der zweiten Werte ($V'_3$, $V'_4$, $V'_5$) der abhängigen Größe, bestimmt nach der besagten linearen Funktion für dieselben Werte ($R_3$, $R_4$, $R_5$) der unabhängigen Größe,
- um die der laufenden linearen Funktionen auszuwählen, die die Näherung aller Paare der besagten Folge mit minimalen Fehlern liefert,
- und um die ausgewählte lineare Regressionsfunktion unter Verwendung von spezifischen Kodes zu kodieren,

und zweite Mittel, um ausgehend von den besagten spezifischen Kodes Befehlsignalwerte (VA) zu berechnen, die zu den besagten zweiten Paaren (RA, VA) für vorbestimmte übertragungswerte (REQ) gehören.

2. Vorrichtung nach Anspruch 1, dadurch gekennzeichnet, daß die Schaltung (26) eine Resonanzschaltung, ein Filter, ein Oszillator, und Phasenverschieber, ein Verstärker ist.

3. Vorrichtung nach einem der Ansprüche 1 oder 2, dadurch gekennzeichnet, daß es sich um eine mit einem Abstimmgerät versehene Vorrichtung handelt, insbesondere einen Fernsehempfänger, einen Radioempfänger, einen Videorecorder.

4. Kodiervorrichtung (22) zur Verwendung in Verbindung mit einer Vorrichtung (20) mit einer Schaltung (26), die als Reaktion auf ein Eingangssignal (IN) ein Ausgangssignal (OUT) abgibt, Mittel (C), um die Werte (R) der besagten Reaktion über mindestens ein Befehlssignal (V) zu ändern, Berechnungsmittel (24) zur Bestimmung der zweiten Übertragungswertepaare, Befehlssignalwerte (RA, VA), ausgehend von einer Näherung erster aus der Schaltung (26) kommender Übertragungswertepaare, Befehlssignalwerte (R1,V1,R6,V6), dadurch gekennzeichnet, daß die Kodiervorrichtung (22) Mittel enthält,

- um iterativ mindestens eine Linearfunktion zu bestimmen, die die Daten eines komplexen Systems zu dessen Darstellung mit einer vereinfachenden Funktion reduziert, die besagte Regressionsfunktion (D) die Näherung einer Folge der besagten ersten Paare (R1,V1)(R6,V6) bildet, durch Gleichmachung in absolutem Wert von ersten Fehlern abwechselnder Zeichen, gemessen zwischen ersten Werten ($V_3$, $V_4$, $V_5$) der abhängigen Größe für drei Paare ($R_3$, $V_3$) ($R_4$, $V_4$) ($R_5$, $V_5$) der besagten Folge und respektive der zweiten Werte ($V'_3$, $V'_4$, $V'_5$) der abhängigen Größe, bestimmt nach der besagten linearen Funktion für dieselben Werte ($R_3$, $R_4$, $R_5$) der unabhängigen Größe,
- um die der laufenden linearen Funktionen auszuwählen, die die Näherung aller Paare der besagten Folge mit minimalen Fehlern liefert,
- und um die lineare Regressionsfunktion zu kodieren, unter Zuhilfenahme spezifischer Kodes auswählt.

5. Für eine Schaltung (26), die als Reaktion auf ein Eingangssignal (IN) ein Ausgangssignal (OUT) abgibt, in dem die Übertragungswerte (R) mit mindestens einem Befehlssignal (V) geändert werden können, ein Verfahren zum Erzeugen einer Näherungsfunktion erster aus der Schaltung kommender Übertragungswertepaare (R1,V1,R6,V6) und zur Bestimmung zweite Übertragungswertepaare, Befehlssignalwerte (RA, VA) ausgehend von der besagten Näherungsfunktion, dadurch gekennzeichnet, daß das Verfahren eine erste Phase umfaßt,

- um iterativ mindestens eine Linearfunktion zu bestimmen, die die Daten eines komplexen Systems zu dessen Darstellung mit einer vereinfachenden Funktion reduziert, die besagte Regressionsfunktion (D) die Näherung einer Folge der besagten ersten Paare (R1,V1)(R6,V6) bildet, durch Gleichmachung in absolutem Wert von ersten Fehlern abwechselnder Zeichen, gemessen zwischen ersten Werten ($V_3$, $V_4$, $V_5$) der abhängigen Größe für drei Paare ($R_3$, $V_3$) ($R_4$, $V_4$) ($R_5$, $V_5$) der besagten Folge und respektive der zweiten Werte ($V'_3$, $V'_4$, $V'_5$) der abhängigen Größe, bestimmt nach der besagten linearen Funktion für dieselben Werte ($R_3$, $R_4$, $R_5$) der unabhängigen Größe,
- um die der laufenden linearen Funktionen auszuwählen, die die Näherung aller Paare der besagten Folge mit minimalen Fehlern liefert,
- und um die lineare Regressionsfunktion zu kodieren, unter Zuhilfenahme spezifischer Kodes auswählt,

und eine zweite Phase, um ausgehend von den besagten spezifischen Kodes Befehlssignalwerte (VA) zu berechnen, die zu den besagten zweiten Paaren (RA, VA) für vorbestimmte Übertragungswerte (REQ) gehören.

6. Verfahren nach Anspruch 5, dadurch gekennzeichnet, daß jedes Wertepaar mit einem spezifischen Bewertungskoeffizienten verbunden ist, der den besagten ersten, sich darauf beziehenden Fehler bewertet.


**Claims**

1. An apparatus (20) comprising a circuit (26) which supplies an output signal (OUT) in response to an input signal (IN), means (C) for changing values (R) of said response by means of at least one control signal (V), calculation means (24) for determining second pairs (RA, VA) of response values, control signal values on the basis of an approximation of first pairs (R1, V1) (R6, V6) of response values, control signal values issuing from the circuit (26), characterized in that the apparatus comprises first means

   - for iteratively determining at least one linear function which reduces data of a complex phenomenon in order to represent as a simplified function called regression function (D) forming the approximation to a series of said first pairs (R1, V1) (R6, V6) by making first errors of alternating signs equal in absolute value, which first errors have been measured between, respectively, first values ($V_3$, $V_4$, $V_5$) of the dependent variable for three pairs ($R_3$, $V_3$), ($R_4$, $V_4$), ($R_5$, $V_5$) of said series, and second values ($V'_3$, $V'_4$, $V'_3$) of the dependent variable determined, in accordance with said linear function, for the same values ($R_3$, $R_4$, $R_5$) of the independent variable,
   - for selecting that one of the current linear functions which produces the approximation of all the pairs of said series with minimal errors, and
   - for coding the selected linear regression function with the aid of specific codes, and
   - second means for calculating, on the basis of said specific codes, control signal values (VA) belonging to said second pairs (RA, VA) for predetermined response values (REQ).

2. An apparatus as claimed in Claim 1, characterized in that the circuit (26) is a resonant circuit, a filter, an oscillator, a phase shifter, an amplifier.

3. An apparatus as claimed in Claim 1 or 2, characterized in that it is an apparatus provided with a tuner, notably a television receiver, a radio receiver, a video recorder.

4. A coding device (22) intended for use in conjunction with an apparatus (20) comprising a circuit (26) which supplies an output signal (OUT) in response to an input signal (IN), means (C) for changing values (R) of said response by means of at least one control signal (V), calculation means (24) for determining second pairs (RA, VA) of response values, control signal values on the basis of an approximation of first pairs (R1, V1, R6, V6) of response values, control signal values issuing from the circuit (26), characterized in that the coding device (22) comprises means

   - for iteratively determining at least one linear function which reduces data of a complex phenomenon in order to represent as a simplified function called regression function (D) forming the approximation to a series of said first pairs (R1, V1) (R6, V6) by making first errors of alternating signs equal in absolute value, which first errors have been measured between, respectively, first values ($V_3$, $V_4$, $V_5$) of the dependent variable for three pairs ($R_3$, $V_3$), ($R_4$, $V_4$), ($R_5$, $V_5$) of said series, and second values ($V'_3$, $V'_4$, $V'_3$) of the dependent variable determined, in accordance with said linear function, for the same values ($R_3$, $R_4$, $R_5$) of the independent variable,

- for selecting that one of the current linear functions which produces the approximation of all the pairs of said series with minimal errors, and
- for coding the selected linear regression function with the aid of specific codes.

5. For a circuit (26) which supplies an output signal (OUT) in response to an input signal (IN), in which response values (R) can be changed by means of at least one control signal (V), a method of generating a function of approximation to first pairs (R1, V1, R6, V6) of response values, control signal values issuing from the circuit, and of determining second pairs (RA, VA) of response values, control signal values on the basis of said approximation function, characterized in that the method comprises a first phase:

- for iteratively determining at least one linear function which reduces data of a complex phenomenon in order to represent as a simplified function called regression function (D) forming the approximation to a series of said first pairs (R1, V1) (R6, V6) by making first errors of alternating signs equal in absolute value, which first errors have been measured between, respectively, first values ($V_3$, $V_4$, $V_5$) of the dependent variable for three pairs ($R_3$, $V_3$), ($R_4$, $V_4$), ($R_5$, $V_5$) of said series, and second values ($V'_3$, $V'_4$, $V'_3$) of the dependent variable determined, in accordance with said linear function, for the same values ($R_3$, $R_4$, $R_5$) of the independent variable,
- for selecting that one of the current linear functions which produces the approximation of all the pairs of said series with minimal errors, and
- for coding the selected linear regression function with the aid of specific codes,

and a second phase for calculating, on the basis of said specific codes, control signal values (VA) belonging to said second pairs (RA, VA) for predetermined response values (REQ).

6. A method as claimed in Claim 5, characterized in that a specific weighting coefficient is associated with each pair of values, which coefficient weights said first error relating thereto.

FIG.1

FIG.2

FIG.3

FIG.4

FIG.5

FIG.6A

FIG.6B

FIG.7

FIG.8

FIG.9